# EUROPEAN PATENT APPLICATION

(11) **EP 0 869 543 A2**
(43) Date of publication of application: **07.10.1998**
(21) Application number: 98302646.9
(22) Date of filing: 03.04.1998
(51) Int. Cl.: H01L 21/00

(54) **Method and apparatus for reducing the first wafer effect**

(30) Priority: 04.04.1997 US 833404
(71) Applicant: Applied Materials, Inc., Santa Clara, California 95054 (US)
(72) Inventor: Ngan, Kenny King-Tai, Fremont, California 94539 (US)
(74) Representative: Bayliss, Geoffrey Cyril

(57) **Abstract**

A method and apparatus for significantly reducing and even eliminating the First Wafer Effect is disclosed. In a first aspect, the First Wafer Effect is reduced by heating a deposition chamber (following an idle period) to its steady-state temperature by using a coil to which RF power is applied. In a second aspect, the First Wafer Effect is reduced by similarly heating a deposition chamber (following an idle period) to a temperature greater than its steady-state temperature and then cooling the chamber to its steady-state temperature. Preferably a gas is flowed into the deposition chamber in both the first and second aspects to increase the chamber's heating rate. Further, a DC voltage may be applied to the deposition chamber's target to cause sputtering of target material on non-production objects for target conditioning.

## Description

This invention relates to thin film deposition and more specifically to a method and apparatus for maintaining consistently high quality deposited films regardless of chamber idle time.

Thin film deposition is essential to the manufacture of solid state electronic devices. By layering various materials on a wafer in a prescribed pattern ("patterning"), a solid state electronic device is formed. Within the semiconductor device industry there is an ever present trend for more complex multi-layer structures and smaller device dimensions. As a result, patterned wafer costs continue to rise, with some patterned wafers costing as much as $100,000. Because a single poor quality layer can destroy the entire wafer, consistent deposition of high quality material layers is essential.

Commercial scale semiconductor device fabrication takes place within automated systems having multiple chambers. Frequently these chambers idle either between shifts, during changeover from one process configuration to another, or during equipment repair. During equipment repair not only does the malfunctioning chamber idle, but also upstream and downstream chambers in perfect operating condition idle. When a hot deposition chamber (i.e., a chamber equipped with a mechanism for heating a wafer to about 300 °C to 600 °C) idles for as brief a duration as 20 to 30 minutes, the material layers ("films") deposited on the first few wafers following the idle period undesirably exhibit lower reflectance (a manifestation of broad distribution in crystal orientation that can result in early electro-migration failure in the resulting device and/or lithographic patterning difficulty when further processed) than do films deposited during steady-state processing (i.e., those periods not following an idle period) and/or exhibit sheet resistance values different from those exhibited by films deposited during normal production. This phenomenon is known as the First Wafer Effect. Thus, following an idle period (i.e., a period sufficient to give rise to the First Wafer Effect) film quality and process reliability deteriorate. Wafers deposited with films that exhibit the First Wafer Effect must be discarded.

The problem presented by the First Wafer Effect will be more fully comprehended with reference to sputtering deposition, a method employed in VLSI and ULSI circuits. Sputtering is one well-known method of depositing a material layer on a semiconductor substrate. A typical sputtering apparatus includes a target and a substrate support pedestal enclosed in a vacuum chamber. The target is typically affixed to the top of the chamber, but is electrically isolated from the chamber walls. A voltage source maintains the target at a negative voltage with respect to the walls of the chamber, creating a voltage differential which excites a gas contained within the vacuum chamber into a plasma. Plasma ions are generated and directed to the target where plasma ion momentum transfers to target atoms, causing the target atoms to be ejected from the target (i.e., to sputter). The sputtered target atoms deposit on the substrate, thereby forming a thin film. Preferably, the thin film is of substantially uniform thickness.

As discussed previously, a constant in the semiconductor device field is the drive for reduced lateral dimensions. In order to reduce the lateral device area of storage capacitors, for example, high aspect ratio (i.e., high depth to width ratio) features (e.g., steps, trenches and vias) have become prevalent. Such features possess large side wall surface areas which allow lateral device dimensions to shrink while maintaining constant capacitor area (and thus a constant capacitance). When sputter depositing a film over a high aspect ratio feature, target material traveling in paths substantially non-perpendicular to the substrate tends to deposit near the top surface (i.e. the surface nearest the deposition material source or target) of the feature and to prevent subsequently deposited material from reaching the feature's lower surface, causing variations in deposition layer thickness including voids (areas containing no deposition material). In order to avoid such undesirable thickness variations a sputtering process known as ionized metal plasma (IMP) has been developed. IMP processing is described in detail in commonly assigned co-pending application serial no. 08/511,825, filed on August 7, 1995 entitled "Method and Apparatus for Low Thermal Budget Metal Filling and Planarization of Contacts, Vias and Trenches."
Generally, an IMP process employs a coil surrounding a sputtering region of a vacuum chamber. The coil is placed so application of RF power to the coil generates an electric field that causes target atoms traveling through the plasma to ionize. The ionized target material is attracted to the substrate (via a potential drop between the plasma region and the substrate and/or via a negative voltage applied to the substrate) along a highly directional, perpendicular path. The perpendicularity of the sputtered ions path enhances coverage of vias, trenches, and the like.

Although IMP processing greatly increases coverage of high aspect ratio features, IMP sputtering chambers are plagued by the inability to overcome the First Wafer Effect experienced after a chamber idle period. The prior art has sought to reduce the First Wafer Effect by preparing the IMP sputtering chamber for production processing (i.e., burning-in the chamber). Prior art burn-in processes apply a DC voltage to the target and flow an inert gas into the chamber to deposit layers of target material on non-production objects (e.g., dummy wafers, the deposition chamber's shutter disk, etc.) The number of layers deposited has varied, ranging as high as eight dummy wafers.

These prior art methods reduce the productivity of the system and increase wafer costs, yet in many cases the first wafer effect still occurs. Thus, a recognized need exists generally within the semiconductor fabrication field, and specifically within the IMP sputter deposition area, for a process that will eliminate the First Wafer Effect. Such a process must be cost effective and must be able to be quickly performed using existing equipment and materials.

Accordingly, it is an object of the present invention to provide a method and apparatus that eliminates or significantly reduces the occurrence of the First Wafer Effect in both standard deposition chambers and in IMP sputter deposition chambers.

It is a further object of the invention to reduce chamber burn-in time, to reduce the number of wafers that must be discarded due to the First Wafer Effect, and thus to reduce the average cost per wafer.

The present invention is directed to a burn-in process that significantly reduces and even eliminates the First Wafer Effect, and to the semiconductor fabrication system that performs the inventive burn-in process. The present invention allows a deposition chamber to be prepared for and to begin depositing production films sooner after an idle period than prior art methods, and results in production films having substantially consistent quality whether the films are deposited immediately after a chamber burn-in or during steady state processing. Thus, the present invention achieves the advantages of increased productivity and reduced cost per wafer. Moreover, the present invention benefits both IMP sputtering chambers and standard deposition chambers, and applies to processes that require target conditioning as well as to processes that do not require target conditioning.

In a first preferred aspect the present invention supplies RF power to a wire coil contained within a deposition chamber to quickly heat the deposition chamber to its steady-state temperature (i.e., the temperature maintained by the chamber during steady-state processing). Because the RF power supplied through the coil heats the chamber much quicker than conventional methods, this preferred aspect of the invention reduces the time required to prepare a hot deposition chamber for production processing after an idle period. The deposition chamber's productive time is thereby increased.

In a second preferred aspect the present invention heats a conventional deposition chamber to a temperature greater than the steady-state temperature and then cools the deposition chamber to the steady-state temperature. Although the RF power signal may be turned off during deposition chamber cooling, application of reduced RF power allows chamber components to cool without experiencing undue thermal stress (e.g., the chamber components experience smaller thermal gradients). This aspect allows application of higher power, thereby increasing the heating ramp rate and reducing chamber heating time. In many applications this preferred aspect of the invention provides shorter burn-in times and allows production processing to begin even more rapidly than does the first aspect of the invention.

Both the first and second aspects of the invention are more efficient when gas, a heat conductor, is flowed into the chamber during burn-in. For deposition chambers that require target conditioning (described below) the gas normally used during production processing is flowed into the deposition chamber, and a DC voltage is applied to the deposition chamber's target to cause sputtering of target atoms onto non-production objects (e.g., dummy wafers, the deposition chamber's shutter disk).

As described above, the present invention reduces the time required for chamber burn-in, and significantly reduces or eliminates occurrence of the First Wafer Effect. This invention widely applies to numerous deposition apparatuses and processes, and specifically benefits IMP sputtering processes.

Other objects, features and advantages of the present invention will become more fully apparent from the following detailed description of the preferred embodiments, the appended claims and the accompanying drawings.
FIG. 1 is a flow diagram for explaining various preferred aspects of the present invention, and for generally outlining a control program for controlling a deposition system in accordance with the present invention; and
FIG. 2 is a diagrammatic illustration, in section, of the pertinent portions of an IMP sputtering chamber 11 suitable or carrying out one embodiment of the present invention.

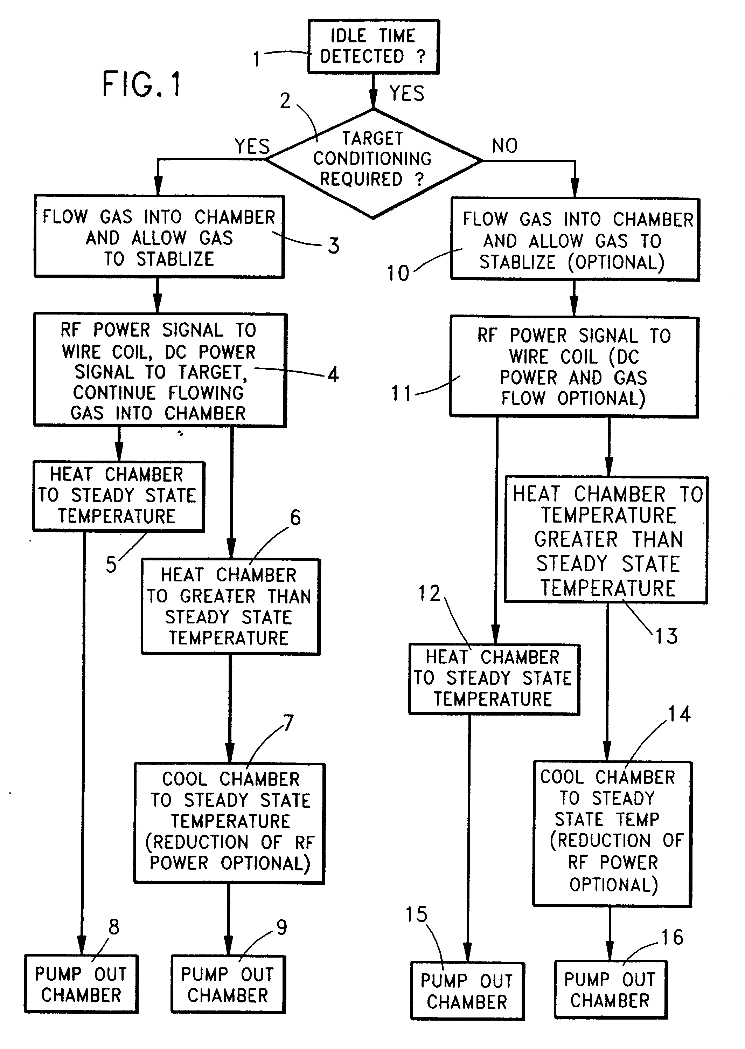

FIG. 1 is a flow diagram for explaining various preferred aspects of the present invention, and for generally outlining a control program for controlling a deposition system in accordance with one embodiment of the present invention.

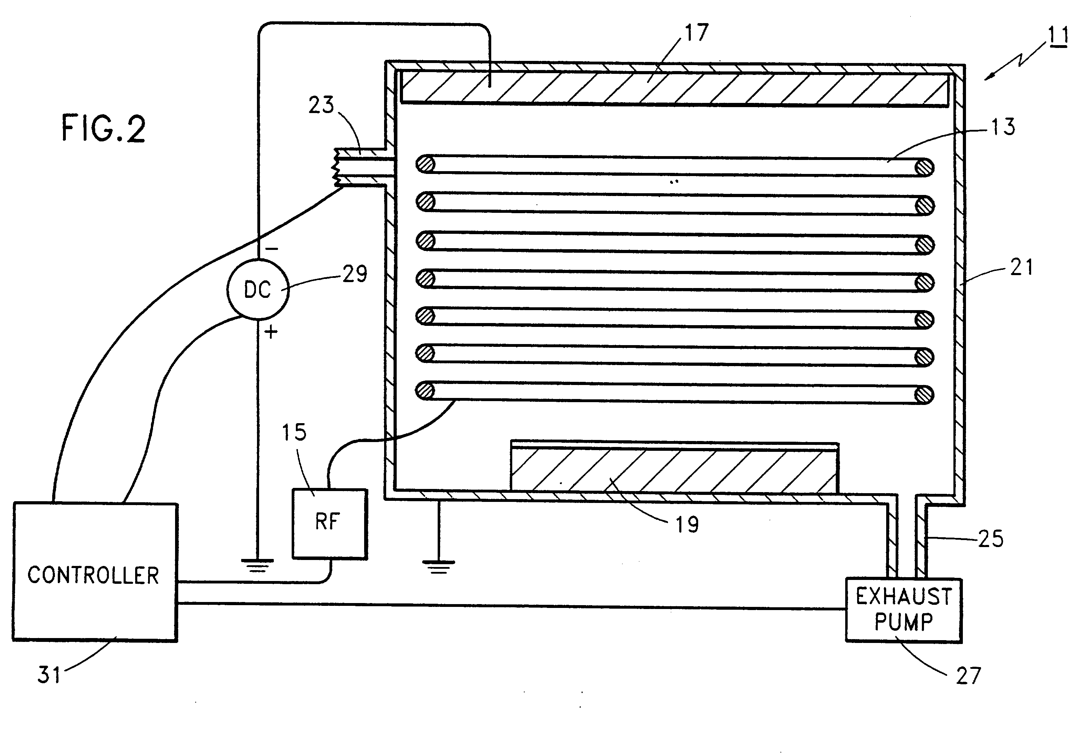

As represented by block 1, a controller (referenced generally by the number "31" in FIG. 2) determines whether a chamber idle period has occurred. Assuming an idle period has occurred, the controller then determines whether target conditioning is required, as represented by block 2. Target conditioning is required when the underlying process (i.e., the process performed on production objects) is such that a process gas film forms on the target during steady-state processing and/or such that an oxide film forms on the target during chamber idle time. In order to maintain consistent film quality during non-steady-state periods, the target must be conditioned until the process gas film forms on the target and/or until any oxide layers have been sputtered from the target.

In order to form a process gas film on the target and/or remove any oxide layers from the target, a DC voltage is applied to the target while the process gas is flowed into the chamber. The DC voltage is sufficient to cause the gas to enter a plasma state. Ions from the gas plasma strike the target and cause atoms of target material, and any oxide film formed thereon, to be sputtered from the target. Some gas ions attach to the target forming a process gas film thereon. Accordingly, as represented by block 3, if the controller determines target conditioning is required, the process chamber's shutter disk is placed between the target and the pedestal, or a dummy wafer is placed within the deposition chamber so that sputtered atoms deposit thereon. The process gas is flowed into the deposition chamber and preferably allowed to stabilize before the process proceeds to block 4.

It has been discovered, in connection with the present invention, that a deposition chamber must be heated to its steady-state temperature in order for layers deposited therein to exhibit a resistivity (or other temperature dependent property) consistent with the resistivity (or other temperature dependent property) exhibited by layers deposited during steady-state processing. A layer's resistivity is affected by the grain orientation and grain size of the layer. For many materials a desired grain orientation and/or a desired grain size is achieved at relatively high temperatures. Therefore it is important when depositing such materials to heat the deposition chamber to its steady-state temperature prior to production processing.

Accordingly, as represented by block 4, in order to ensure consistent deposited layer quality; (1) prior to production processing the target is conditioned to its steady-state condition (e.g., having a process gas film formed thereon) by applying a sufficient DC power signal to the target and (2) prior to production processing the deposition chamber is heated to its steady-state temperature by applying a sufficient RF power signal to the coil. As the DC and RF power signals are applied to the target and the coil, respectively, the process gas continues to flow to the deposition chamber, forming a process gas film on the target. The DC and RF power signals cause the process gas to strike a plasma and plasma energy transfers to deposition chamber components causing the deposition chamber components to heat. The RF power signal applied to the coil is preferably equal to or greater than the RF power signal applied to the coil during the underlying process; a greater power signal provides a faster heating rate.

The controller may be programmed to heat the deposition chamber to a temperature equal to its steady-state temperature, as represented by block 5, or to a temperature greater than its steady-state temperature, as represented by block 6. By heating the deposition chamber to a temperature greater than the steady-state temperature the heating ramp rate can be increased, as a greater RF power signal may be applied to the coil. In this manner significantly faster heating rates are achieved.

As represented by block 7, if the process chamber is heated to a temperature greater than the steady-state temperature, the process chamber must be cooled to its steady-state temperature prior to beginning production processing. The RF power signal may be turned off during deposition chamber cooling, or preferably, may be reduced during deposition chamber cooling. Application of a reduced RF power signal reduces thermal gradients and thereby allows chamber components to cool without experiencing undue thermal stress.

As represented by blocks 8 and 9, after the target has been conditioned and the process chamber has stabilized at its steady-state temperature, the gas flow is turned off and the chamber is pumped down to a predetermined vacuum level. The deposition chamber is then ready to receive an object for production processing.

In the event the target does not need conditioning the gas flow to the chamber is optional. However, gas is preferably flowed into the chamber to facilitate chamber heating as indicated by block 10.

Thereafter as indicated by block 11, an RF power signal is applied to the coil (application of a DC power signal to the target, and/or continued gas flow are also optional). The deposition chamber is then heated to the steady-state temperature (block 12) or to a temperature greater than the steady-state temperature (block 13).

If the chamber is heated to a temperature greater than the steady-state temperature the chamber is preferably cooled to the steady-state temperature prior to production processing as represented by block 14. In order to heat the chamber to a temperature greater than the steady state temperature, higher power levels can be applied and faster heating ramp rates achieved. In many applications the desired steady state temperature can be achieved more quickly by heating the chamber to a temperature greater than the steady state temperature and then cooling the chamber. Chamber cooling is preferably achieved by reducing the RF power signal applied to the coil as previously described with reference to block 7.

After the deposition chamber has stabilized at the steady-state temperature, the chamber is pumped to a predetermined vacuum level as represented by blocks 15 and 16, and the chamber is then ready to receive an object for production processing.

Layers deposited immediately following the inventive burn-in process described above are of approximately the same quality as layers deposited during steady-state processing; moreover the entire burn-in process takes a relatively small amount of time as demonstrated by the specific example described below with reference to FIG. 2.

FIG. 2 is a diagrammatic illustration, in section, of the pertinent portions of an IMP sputtering chamber 11 suitable for putting into practice one embodiment of the present invention. The IMP sputtering chamber 11 contains a wire coil 13 which is operatively coupled to an RF power supply 15. As shown in FIG. 2 the wire coil 13 is positioned along the inner surface of the IMP sputtering chamber 11, between a sputtering target 17 and a substrate support pedestal 19. The substrate support pedestal 19 is positioned in the lower portion of the IMP sputtering chamber 11 and the sputtering target 17 is mounted in the upper portion of the IMP sputtering chamber 11. The IMP sputtering chamber 11 generally includes a vacuum chamber enclosure wall 21 having at least one gas inlet 23 and having an exhaust outlet 25 operatively coupled to an exhaust pump 27. The sputtering target 17 is electrically isolated from the enclosure wall 21. The enclosure wall 21 is preferably grounded so that a negative voltage (with respect to grounded enclosure wall 21) may be applied to the sputtering target 17 via a DC power supply 29 operatively coupled between the target 17 and the enclosure wall 21. A controller 31 is operatively coupled to the RF power supply 15, the DC power supply 29, the gas inlet 23 and the exhaust outlet 25.

In this example assume that the IMP sputtering chamber 11 is configured for deposition of titanium nitride layers and the inventive method is employed in order to achieve layers having consistent resistivity whether deposited following an idle period or during steady-state processing. Further, assume the specific deposition process requires both argon and nitrogen gas to be flowed into the IMP sputtering chamber 11 through the gas inlet 23, while both a 2.5 kW power signal is applied to the wire coil 13 via the RF power supply 15 and a 5 kW power signal is applied to the target 17 via the DC power supply 29. During steady-state processing a nitrogen film forms on the target 17, accordingly target conditioning is required.

In operation, a throttle valve (not shown) operatively coupled to the exhaust outlet 25 is placed in a mid-position in order to maintain the deposition chamber at a desired low vacuum level. A mixture of argon and nitrogen gas is flowed into the IMP sputtering chamber 11 via the gas inlet 23. After the gas stabilizes (approximately 10 seconds), both a 3kW DC power signal is applied to the target 17 via the DC power supply 29 and a 3kW RF power signal is applied to the wire coil 13 via the RF power supply 15, while the gas mixture continues to flow into the IMP sputtering chamber 11 via the gas inlet 23. The DC power applied to the target 17 causes the argon/nitrogen gas mixture to form a plasma and to generate energized plasma particles which strike the target 17 causing target atoms to be ejected therefrom and causing a nitrogen layer to form on the target 17. The RF power applied to the coil 13 causes the IMP sputtering chamber 11 and its components to heat rapidly and additionally causes the ejected target atoms to ionize. After approximately 180 seconds the chamber temperature reaches and exceeds the steady-state process temperature. (It is understood that the heating rate is dependent on the specific size and configuration of the deposition chamber and will vary accordingly).
Preferably in order to cool the IMP sputtering chamber 11 to its steady-state temperature, a 5kW DC power signal is applied to the target 17 and a 1.75kW RF power signal is applied to the wire coil 13. The reduction in the RF power signal allows the IMP sputtering chamber 11 and the components contained therein to cool gradually to the steady-state temperature without being subject to the thermal stress that can occur when an object cools too quickly. After approximately 60 seconds the IMP sputtering chamber 11 cools to the steady-state temperature. Thereafter the gas flow through the gas inlet 23 is shut off, and the throttle valve (not shown) operatively coupled to the gas exhaust outlet 25 is opened so the IMP sputtering chamber 11 is quickly pumped to a high vacuum level and is ready to receive an object for production processing.

Actual test data demonstrates the value of the present invention -- the example 260 second titanium nitride IMP sputtering chamber burn-in described above achieves a 3% resistivity variation over 25 wafers, a significant improvement over the prior art method (5 kW DC applied to the target, 8 minutes burn-in deposition on a total of 5 dummy wafers) which results in a 10% resistivity variation over 25 wafers.

Although the inventive burn-in process described above is directed to a chamber configured for IMP sputtering deposition, the invention is not limited thereto. Any standard deposition chamber may be supplied with a wire coil and an RF power supply in order to benefit from the faster heating rates provided by the RF powered coil. In fact, the sputtering shield of a standard deposition chamber may be split so that an RF power signal may be applied to a portion of the sputtering shield, thereby enabling a standard sputtering shield (with simple modification) to act as both a shield and an RF coil.

The inventive burn-in process is useful for deposition of numerous materials in addition to the titanium nitride described above. Any material having desired properties that are temperature dependent (e.g., crystal orientation, reflectivity, resistivity) will benefit from the present invention. Such materials include but are not limited to titanium, titanium nitride and titanium tungsten nitride. In sum, the foregoing description discloses only the preferred embodiments of the invention, modifications of the above disclosed apparatus and method which fall within the scope of the invention will be readily apparent to those of ordinary skill in the art. For instance, the process conditions are not restricted to those provided in the above example. The acceptable range of the DC power signal depends on hardware temperature limitations; a range of 500W to 30kW is preferred. The acceptable range of the RF power signal is limited only by the thermal properties of the wire coil; 500W to 10kW is presently preferred.

Further it should be understood that, for a given process and a given property, a range of values are considered acceptable. Accordingly values that fall within such a range are considered to be of substantially consistent quality. A desired steady-state property may be any value that falls within a range of values determined to be acceptable. Thus, it will be understood that for a given process a range of temperatures may achieve the desired range of acceptable properties. Such a temperature range is therefore equivalent to the steady-state temperature.

## Claims

1. A method of preparing a deposition chamber for production processing comprising:
applying an RF power signal to a deposition chamber coil; and
heating the deposition chamber to a desired temperature; wherein the RF power signal is applied prior to production processing.

2. The method of claim 1 wherein the RF power applied to the deposition chamber coil is greater than an RF power signal applied to the deposition chamber coil during production processing.

3. The method of claim 2 wherein the desired temperature is a temperature greater than a steady-state processing temperature, said method further comprising cooling the deposition chamber to the steady state processing temperature.

4. The method of claim 3 further comprising flowing a gas into the deposition chamber while applying RF power to the deposition chamber coil.

5. The method of claim 4 further comprising applying a DC voltage to a target of the deposition chamber while flowing the gas into the deposition chamber.

6. The method of claim 5 further comprising sputtering target material onto a non-production object within the deposition chamber.

7. The method of claim 2 wherein the desired temperature is a steady state processing temperature.

8. The method of claim 7 further comprising flowing a gas into the deposition chamber while applying RF power to the deposition chamber coil.

9. The method of claim 9 further comprising applying a DC voltage to a target of the deposition chamber while flowing the gas into the deposition chamber.

10. The method of claim 9 further comprising sputtering target material onto a non-production object within the deposition chamber.

11. The method of claim 2 wherein the RF power applied to the deposition chamber coil is equal to a power signal applied to the deposition chamber coil during production processing.

12. The method of claim 11 wherein the desired temperature is a steady state processing temperature.

13. The method of claim 12 further comprising flowing a gas into the deposition chamber while applying RF power to the deposition chamber coil.

14. The method of claim 13 further comprising applying a DC voltage to a target of the deposition chamber while flowing the gas into the deposition chamber.

15. The method of claim 14 further comprising sputtering target material onto a non-production object within the deposition chamber.

16. A method of producing semiconductor wafers comprising:
after an idle period, applying RF power to a coil within a deposition chamber to heat the deposition chamber to at least a steady state temperature; and
after the deposition chamber is heated to the desired temperature, beginning production processing.

17. A deposition system comprising:
a deposition chamber;
a coil within said deposition chamber; and
a controller for applying RF power to said coil after an idle period and before production processing.
